# EUROPÄISCHE PATENTANMELDUNG

(11) **EP 1 197 575 A2**
(43) Veröffentlichungstag der Anmeldung: **17.04.2002**
(21) Anmeldenummer: 01117904.1
(22) Anmeldetag: 24.07.2001
(51) Int. Cl.: C23C 14/20, F16L 11/04

(54) **Verfahren zum Herstellen eines metallisierten Kunststoffschlauches, insbesondere eines Brauseschlauches**

(30) Priorität: 11.10.2000 DE 10054671; 26.03.2001 DE 10114711
(71) Anmelder: Kludi GmbH & Co. KG, 58706 Menden (DE)
(72) Erfinder: Katzer, Dieter, 49401 Damme (DE); Kraus, Thomas, 58706 Menden (DE)
(74) Vertreter: COHAUSZ HANNIG DAWIDOWICZ & PARTNER

(57) **Zusammenfassung**

Die Erfindung betrifft ein Verfahren zum Herstellen eines Kunststofffschlauches, insbesondere für den Sanitärbereich mit einer metallisierten Oberfläche, wobei die Metallisierung direkt auf die Außenseite des Schlauches aufgebracht wird.

## Beschreibung

Die Erfindung betrifft ein Verfahren zum Herstellen eines Kunststofffschlauches, insbesondere für den Sanitärbereich mit einer metallisierten Oberfläche.

Es ist aus der EP 685 676 bekannt, eine metallisierte Heißprägefolie auf die Außenseite eines Brauseschlauches aufzubringen. Dies ist verhältnismäßig arbeitsaufwendig.

Aufgabe der Erfindung ist es, einen Kunststoffschlauch, insbesondere einen Kunststoffbrauseschlauch außen mit einer Färbung insbesondere mit einer Metallisierung zu versehen, ohne hierzu den Schlauch außen mit einer Kunststofffolie oder einem anderen Trägermaterial versehen zu müssen.

Diese Aufgabe wird erfindungsgemäß dadurch gelöst, dass die Metallisierung direkt auf die Außenseite des Schlauches aufgebracht wird.

Die metallisierende Oberfläche wird direkt unter Vakuum auf den Schlauch gedampft ohne den Umweg über bedampfte Folien oder Heißprägefolien zu gehen. Es ist eine wesentliche Einsparung, dass eine Folie nicht mehr aufgebracht werden muss. Durch den Wegfall dieser Schritte im Herstellungsprozess sind wesentliche Kosten einzusparen. Da die aufgedampfte Schicht sehr viel dünner ist als Heißpräge- oder andere metallbedampfte Folien, ist der Schlauch flexibler und die Wahrscheinlichkeit von Beschädigungen beim Biegen des Schlauches erheblich geringer.

Vorteilhafte Ausgestaltungen der Erfindung sind in den Unteransprüchen aufgeführt.

Ausführungsbeispiele der Erfindung werden im folgenden näher beschrieben.

Kunststoffschläuche werden im Sanitärbereich, insbesondere als Brauseschläuche häufig verwendet. Um der Außenseite des Kunststoffschlauches ein metallisches Äußeres zu geben, wird die Metallisierung direkt auf die Außenseite des Schlauches aufgebracht. Hierbei wird die Metallisierung durch Bedampfen unter Vakuum aufgebracht, wobei zum Erzeugen des Metalldampfs Metall zuvor geschmolzen wird.

Die Schlauchoberfläche wird vollständig unter Vakuum bedampft, ohne den Schlauch zur Exposition in Drehung zu versetzen oder die Bedampfungseinrichtung um den Schlauch rotieren zu lassen. Auch kann der Metallniederschlag auf der Schlauchoberfläche durch Magnetfelder abgelenkt werden, um die vollflächige Bedampfung zu erreichen.

Die Außenseite des Schlauches kann auch durch ein Sputtern mit Metall beschichtet werden. Hierbei befinden sich in einem evakuierten Behälter eine Kathode (negativer Pol), ein metallisches Target (das zu zerstäubende Beschichtungsmaterial), der zu beschichtende Schlauch, eine Anode (positiver Pol, oft die Behälterinnenwand) und ein Prozessgas (insbesondere Argon mit Stickstoff oder ähnliche Gasgemische). Im elektrischen Feld (Plasma) werden die Argon-Atome inonisiert und die positiv geladenen Teilchen zur Kathode u nd zum Target beschleunigt. Hierbei verdampft Material des Targets und kondensiert auf der Oberfläche des Schlauches.

Alternativ dazu wird der Schlauch um einen bestimmten Winkel zu seiner Längsachse geschwenkt, um den Metallniederschlag auf die gesamte Schlauchoberfläche zu bringen und damit eine vollflächige Bedampfung zu erreichen oder die Einrichtung zum Bedampfen wird mindestens um einen bestimmten Winkel um den Schlauch geschwenkt.

Die bedampfte Schicht ist im wesentlichen eine Dekorschicht und ist mit einer weiteren Schutzschicht überzogen. Die Schutzschicht bedeckt vollständig die Dekorschicht des Schlauches. Die Schutzschicht ist mindestens teilweise durchsichtig und gibt den Blick zur Dekorschicht frei. Die Schutzschicht enthält teilweise selbst Dekorelemente und bedeckt die Dekorschicht vollständig.

## Patentansprüche

1. Verfahren zum Herstellen eines Kunststofffschlauches, insbesondere für den Sanitärbereich mit einer metallisierten Oberfläche, **dadurch gekennzeichnet, dass** die Metallisierung direkt auf die Außenseite des Schlauches aufgebracht wird.

2. Verfahren nach Anspruch 1, **dadurch gekennzeichnet, dass** die Metallisierung durch Bedampfen mit geschmolzenem Metall vorzugsweise unter Vakuum aufgebracht wird.

3. Verfahren nach Anspruch 1 oder 2, **dadurch gekennzeichnet, dass** die Schlauchoberfläche vollständig unter Vakuum bedampft wird, ohne den Schlauch zur Exposition in Drehung zu versetzen oder die Bedampfungseinrichtung um den Schlauch rotieren zu lassen.

4. Verfahren nach einem der vorherigen Ansprüche, **dadurch gekennzeichnet, dass** der Metallniederschlag auf der Schlauchoberfläche durch Magnetfelder abgelenkt wird, um die vollflächige Bedampfung zu erreichen.

5. Verfahren nach einem der vorherigen Ansprüche, **dadurch gekennzeichnet, dass** der Schlauch mindestens um einen bestimmten Winkel zu seiner Längsachse geschwenkt wird, um den Metallniederschlag auf die gesamte Schlauchoberfläche zu bringen und damit eine vollflächige Bedampfung zu erreichen.

6. Verfahren nach einem der vorherigen Ansprüche, **dadurch gekennzeichnet, dass** die Einrichtung zum Bedampfen mindestens um einen bestimmten Winkel um den Schlauch geschwenkt wird, um eine vollflächige Bedampfung des Schlauches zu erreichen.

7. Verfahren nach einem der vorherigen Ansprüche, **dadurch gekennzeichnet, dass** die bedampfte Schicht im wesentlichen eine Dekorschicht ist und diese mit einer weiteren Schicht überzogen ist.

8. Verfahren nach Anspruch 7, **dadurch gekennzeichnet, dass** die Schicht über der aufgedampften Dekorschicht eine Schutzschicht ist.

9. Verfahren nach Anspruch 7 oder 8, **dadurch gekennzeichnet, dass** die Schutzschicht vollständig die Dekorschicht des Schlauches bedeckt.

10. Verfahren nach einem der Ansprüche 7 bis 9, **dadurch gekennzeichnet, dass** die Schutzschicht mindestens teilweise durchsichtig ist und den Blick zur Dekorschicht freigibt.

11. Verfahren nach einem der Ansprüche 7 bis 10, **dadurch gekennzeichnet, dass** die Schutzschicht teilweise selbst Dekorelemente enthält und die Dekorschicht vollständig bedeckt.

12. Verfahren nach einem der vorherigen Ansprüche, **dadurch gekennzeichnet, dass** die Schlauchaußenseite durch ein Sputtern mit Metall beschichtet wird.
